(19) Europäisches Patentamt
European Patent Office
Office européen des brevets

(11) **EP 3 611 574 A1**

(12) **EUROPÄISCHE PATENTANMELDUNG**

(43) Veröffentlichungstag:
**19.02.2020  Patentblatt 2020/08**

(51) Int Cl.:
*G03H 5/00* (2006.01)  *G03H 1/22* (2006.01)

(21) Anmeldenummer: **18188717.5**

(22) Anmeldetag: **13.08.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Technische Universität Berlin**
**10623 Berlin (DE)**

(72) Erfinder:
• WAGNER, Tolga
  **13507 Berlin (DE)**
• LEHMANN, Michael
  **12557 Berlin (DE)**
• NIERMANN, Tore
  **10823 Berlin (DE)**

(74) Vertreter: **Fischer, Uwe**
**Patentanwalt**
**Moritzstraße 22**
**13597 Berlin (DE)**

(54) **ANORDNUNG UND VERFAHREN ZUM ERFASSEN EINES MESSWERTES AUF DER BASIS VON ELEKTRONENHOLOGRAPHIE**

(57)  Die Erfindung bezieht sich auf ein Verfahren zum Erfassen eines Messwerts (dφ/dx, M). Erfindungsgemäß ist vorgesehen, dass ein sinusförmiges Anregungssignal (Ue) mit einer vorgegebenen Anregungsfrequenz (f), mit oder ohne überlagerten Gleichanteil (Uoffset), an einem Eingang eines Bauelements (100, C) eingespeist wird, zumindest ein Elektronenholographiemessschritt durchgeführt wird, bei dem auf das Bauelement (100, C) ein Elektronenstrahl (Se) gerichtet wird, der das Bauelement (100, C) durchdringt und/oder passiert und anschließend mit einem Referenzelektronenstrahl (Sr) überlagert wird, und ein durch Interferenz der zwei Elektronenstrahlen (Se, Sr) während eines vorgegebenen Messfensters (F) entstehendes Elektronenhologramm (EHG) gemessen und daraus ein Phasenbild (PB) ermittelt wird, und anhand des Phasenbildes (PB) der Messwert (M) gebildet wird, wobei die zeitliche Länge (Tf) des Messfensters (F) des Elektronenholographiemessschritts kleiner ist als die Hälfte der Periodendauer (T) des sinusförmigen Anregungssignals (Ue).

Fig. 6

**Beschreibung**

Die Erfindung bezieht sich auf ein Verfahren zum Erfassen eines Messwertes unter Einbezug zumindest eines Elektronenholographiemessschrittes.

Der Erfindung liegt die Aufgabe zugrunde, ein Messverfahren anzugeben, das in relativ einfacher Weise auch für sehr kleine Bauelemente, die nur eingeschränkt zugänglich sind, Messwerte liefern kann.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass ein sinusförmiges Anregungssignal mit einer vorgegebenen Anregungsfrequenz, mit oder ohne überlagerten Gleichanteil, an einem Eingang eines Bauelements eingespeist wird, zumindest ein Elektronenholographiemessschritt durchgeführt wird, bei dem auf das Bauelement ein Elektronenstrahl gerichtet wird, der das Bauelement durchdringt und/oder passiert und anschließend mit einem Referenzelektronenstrahl überlagert wird, und ein durch Interferenz der zwei Elektronenstrahlen während eines vorgegebenen Messfensters entstehendes Elektronenhologramm gemessen und daraus ein Phasenbild ermittelt wird, und anhand des Phasenbildes der Messwert gebildet wird, wobei die zeitliche Länge des Messfensters des Elektronenholographiemessschritts kleiner ist als die Hälfte der Periodendauer des sinusförmigen Anregungssignals.

Ein wesentlicher Vorteil des erfindungsgemäßen Verfahrens ist darin zu sehen, dass die zeitliche Länge der Elektronenholographiemessschritte bzw. die zeitliche Länge der Messfenster bei jedem Elektronenholographiemessschritt jeweils an die Periodendauer des sinusförmigen Anregungssignals angepasst wird, und zwar dergestalt, dass die Messfensterlänge stets kleiner ist als die Hälfte der Periodendauer. Durch diese Dimensionierung der Messfensterlänge lässt sich erreichen, dass das Phasenbild stets zur Bildung des Messwertes herangezogen werden kann, beispielsweise indem die Änderung der Phase über dem Ort quantitativ ausgewertet wird.

Ein weiterer wesentlicher Vorteil des erfindungsgemäßen Verfahrens ist darin zu sehen, dass das Verfahren das Messen elektrischer oder magnetischer Feldstärken, elektrischer Spannungen oder elektrischer Ströme auch für sehr kleine Bauelemente ermöglicht, die von außen nur schwer zugänglich sind und beispielsweise selbst nicht kontaktiert werden können.

Vorteilhaft ist es, wenn die Lage des Messfensters relativ zu den Stellen maximaler Steigung des Anregungssignals derart gewählt wird, dass das Messfenster zwischen diesen Stellen liegt und diese nicht einschließt. Bei dieser Ausgestaltung lassen sich besonders ungestörte Phasenbilder erzielen, die besonders einfach auswertbar sind.

Wird in das Bauelement ein sinusförmiges Anregungssignal ohne überlagerten Gleichanteil eingespeist, so ist es also vorteilhaft, wenn die Lage des Messfensters relativ zu den Nulldurchgängen derart gewählt wird, dass das Messfenster zwischen den Nulldurchgängen liegt und diese nicht einschließt.

Besonders vorteilhaft ist es, wenn die Lage des Messfensters derart gewählt wird, dass es eine Extremstelle, also entweder ein Maximum oder ein Minimum, des Anregungssignals erfasst. In den Bereichen einer Extremstelle ist das Anregungssignal zeitlich relativ konstant und ermöglicht somit besonders genaue Messergebnisse.

Die Lage des Messfensters wird vorzugsweise derart gewählt, dass die Fenstermitte an der oder zumindest im Bereich der Extremstelle des Anregungssignals liegt.

Mit Blick auf eine Charakterisierung des Bauelements für unterschiedliche Frequenzen, insbesondere für die Ermittlung eines Frequenzganges des Bauelements, wird es als vorteilhaft angesehen, wenn zumindest zwei Elektronenholographiemessschritte der beschriebenen Art nacheinander mit unterschiedlichen Anregungsfrequenzen durchgeführt werden.

Bei der letztgenannten Variante ist es vorteilhaft, wenn bei jedem der Elektronenholographiemessschritte die Länge des Messfensters und die jeweilige Periodenlänge des sinusförmigen Anregungssignals aneinander angepasst werden, und zwar derart, dass das Verhältnis zwischen der Länge des Messfensters und der jeweiligen Periodenlänge des Anregungssignals bei allen Elektronenholographiemessschritten gleich groß ist.

Auch ist es vorteilhaft, wenn bei jedem der Elektronenholographiemessschritte - unabhängig von der jeweiligen Anregungsfrequenz - die Lage der Messfenster bezogen auf den zeitlichen Verlauf des Anregungssignals stets gleich ist. Vorzugsweise liegt die Fenstermitte stets an der oder zumindest im Bereich der ausgewählten Extremstelle des Anregungssignals.

Auch wird es als vorteilhaft angesehen, wenn anhand des Phasenbildes die Änderung der Phase über dem Ort unter Bildung eines Steigungswerts ermittelt wird und als der Messwert der Steigungswert ausgegeben wird oder mit dem Steigungswert der Messwert gebildet wird, insbesondere durch Multiplikation mit einer Konstante.

Als Messwert wird vorzugsweise die an dem Bauelement anliegende elektrische Spannung oder der durch das Bauelement fließende Strom ermittelt. Alternativ oder zusätzlich können Feldstärken elektrischer oder magnetischer Felder gemessen werden.

Die zeitliche Länge des Messfensters ist vorzugsweise kleiner als ein Fünftel der Periodendauer des Anregungssignals, insbesondere kleiner als ein Achtel, vorzugsweise kleiner als ein Zehntel und besonders bevorzugt kleiner als ein Zwanzigstel der Periodendauer des Sinussignals. Je kürzer die Länge des Messfensters ist, umso konstanter ist das Anregungssignal in dem Messfenster, jedoch wird das Phasenbild wegen der Kürze der Messzeit immer grobkörniger und die Auswertbarkeit verschlechtert sich. Der Bereich zwischen 1/5 und 1/100 der Periodendauer des Sinussignals stellt für die zeitliche Länge des Messfensters somit ein Optimum dar.

Bezüglich der Ermittlung eines Frequenzgangs wird es als vorteilhaft angesehen, wenn eine Vielzahl an Elektronenholographiemessschritten der beschriebenen Art nacheinander mit unterschiedlichen Anregungsfrequenzen durchgeführt wird und in jedem Elektronenholographiemessschritt jeweils ein Verhältniswert zwischen der Amplitude des sinusförmigen Anregungssignals und dem Messwert errechnet wird und mit den Verhältniswerten ein Frequenzgang des Bauelements ermittelt wird.

Alternativ ist es von Vorteil, wenn die Lage des Messfensters, insbesondere die Lage der Fenstermitte, relativ zu den Stellen maximaler Änderung der Phase derart gewählt wird, dass das Messfenster an diesen oder zumindest im Bereich dieser Stellen liegt.

Die Erfindung bezieht sich darüber hinaus auf eine Anordnung zum Erfassen eines Messwertes. Erfindungsgemäß weist die Anordnung auf:

- einen Sinusgenerator, der ein sinusförmiges Anregungssignal mit einer vorgegebenen Anregungsfrequenz, mit oder ohne überlagerten Gleichanteil, erzeugen und in ein Bauelement einspeisen kann,
- ein Elektronenholographiemessgerät zur Durchführung eines Elektronenholographiemessschritts, bei dem

  - auf das Bauelement ein Elektronenstrahl gerichtet wird, der das Bauelement durchdringt und/oder passiert und anschließend mit einem Referenzelektronenstrahl überlagert wird, und
  - ein durch Interferenz der zwei Elektronenstrahlen während eines vorgegebenen Messfensters entstehendes Elektronenhologramm gemessen und daraus ein Phasenbild ermittelt wird,

- eine Auswerteinheit zur Bildung des Messwertes anhand des Phasenbildes, und
- eine Messfenstersteuereinheit, die derart ausgebildet ist, dass sie die Lage und Länge des Messfensters bestimmt, und zwar derart, dass die zeitliche Länge des Messfensters des Elektronenholographiemessschritts kleiner ist als die Hälfte der Periodendauer des sinusförmigen Anregungssignals.

Bezüglich der Vorteile der erfindungsgemäßen Anordnung sei auf die obigen Ausführungen im Zusammenhang mit dem erfindungsgemäßen Verfahren verwiesen.

Die Messfenstersteuereinheit ist vorzugsweise derart ausgebildet ist, dass sie

- die Lage des Messfensters relativ zu den Stellen maximaler Steigung des Anregungssignals derart wählt, dass das Messfenster zwischen diesen Stellen liegt und diese nicht einschließt, und/oder

- die Lage des Messfensters derart wählt, dass das Messfenster eine Extremstelle, also entweder ein Maximum oder ein Minimum, des Anregungssignals erfasst, und/oder
- die Lage des Messfensters derart wählt, dass die Fenstermitte an der oder zumindest im Bereich einer Extremstelle des Anregungssignals liegt, und/oder
- die Lage des Messfensters derart wählt, dass das Messfenster an mehreren äquidistanten Stellen, zumindest jedoch vier äquidistanten Stellen des Anregungssignals liegt, um mehrere, zumindest aber vier, Elektronenholographiemessschritte nacheinander bei gleichen Periodenlängen des Anregungssignals durchzuführen und/oder
- im Falle mehrerer Elektronenholographiemessschritte nacheinander mit unterschiedlichen Periodenlängen des Anregungssignals bei jedem Elektronenholographiemessschritt jeweils die Länge des Messfensters an die jeweilige Periodenlänge des Anregungssignals anpasst, und zwar derart, dass das Verhältnis zwischen der Länge des Messfensters und der jeweiligen Periodenlänge des Anregungssignals bei allen Elektronenholographiemessschritten gleich groß ist, und/oder
- im Falle mehrerer Elektronenholographiemessschritte nacheinander mit unterschiedlichen Periodenlängen des Anregungssignals bei jedem Elektronenholographiemessschritt jeweils die Lage des Messfensters an die jeweilige Periodenlänge des Anregungssignals anpasst, und zwar derart, dass die Lage des Messfensters bezogen auf den zeitlichen Verlauf des Anregungssignals, insbesondere bezogen auf die Extremstellen des Anregungssignals, bei allen Elektronenholographiemessschritten gleich ist.

Die Auswerteinheit ist vorzugsweise derart ausgebildet, dass sie anhand des Phasenbildes die Änderung der Phase über dem Ort unter Bildung eines Steigungswerts ermittelt und als Messwert den Steigungswert ausgibt oder mit dem Steigungswert den Messwert bildet, insbesondere durch Multiplikation mit einer Konstante.

Eine Sortiereinheit der Anordnung ist vorzugsweise derart ausgebildet, dass sie Steigungswerte nach dem betragsmäßig höchsten Steigungswert sortiert und mit diesem betragsmäßig höchsten Steigungswert den Messwert bildet, insbesondere durch Multiplikation mit einer Konstante.

Die Erfindung wird nachfolgend anhand von Ausführungsbeispielen näher erläutert; dabei zeigen beispielhaft

Figur 1      ein Ausführungsbeispiel für eine erfindungsgemäße Anordnung zum Erfassen eines Messwertes,

Figur 2    ein Ausführungsbeispiel für ein Bauelement, an dem eine Spannung anliegt, deren Höhe mit der Anordnung gemäß Figur 1 gemessen werden kann,

Figur 3    ein Elektronenmikroskopiebild des Bauelements gemäß Figur 2,

Figur 4    ein Ausführungsbeispiel für ein Anregungssignal, das von einem Sinusgenerator der Anordnung gemäß Figur 1 erzeugt werden kann,

Figur 5    ein Ausführungsbeispiel für ein Elektronenhologramm, das von einem Elektronenholographiemessgerät der Anordnung gemäß Figur 1 für das Bauelement gemäß den Figuren 2 und 3 erzeugt worden ist, und zwar für eine Anregungsfrequenz von 1 kHz,

Figur 6    ein Ausführungsbeispiel für ein aus dem Elektronenhologramm gemäß Figur 5 rekonstruiertes Phasenbild, anhand dessen ein Messwert, hier ein Messwert für die an dem Bauelement gemäß den Figuren 2 und 3 bei der Anregungsfrequenz von 1 kHz anliegende Bauelementspannung, ermittelt worden ist,

Figur 7    ein aus einem Elektronenhologramm bei einer Anregungsfrequenz von 3 MHz rekonstruiertes Phasenbild, anhand dessen ein Messwert für die an dem Bauelement gemäß den Figuren 2 und 3 bei dieser Anregungsfrequenz anliegende Bauelementspannung ermittelt worden ist, und

Figur 8    ein weiteres Ausführungsbeispiel für ein Anregungssignal, das von einem Sinusgenerator der Anordnung gemäß Figur 1 erzeugt werden kann,

Figur 9    ein Ausführungsbeispiel für eine alternative erfindungsgemäße Anordnung zum Erfassen eines Messwertes,

Figur 10   ein Ausführungsbeispiel für eine Analyse der Steigungswerte bei äquidistanten Messfensterpositionen zur Ermittlung des betragsmäßig höchsten Steigungswertes durch eine Sortiereinheit der Anordnung gemäß Figur 9.

In den Figuren werden der Übersicht halber für identische oder vergleichbare Komponenten stets dieselben Bezugszeichen verwendet.

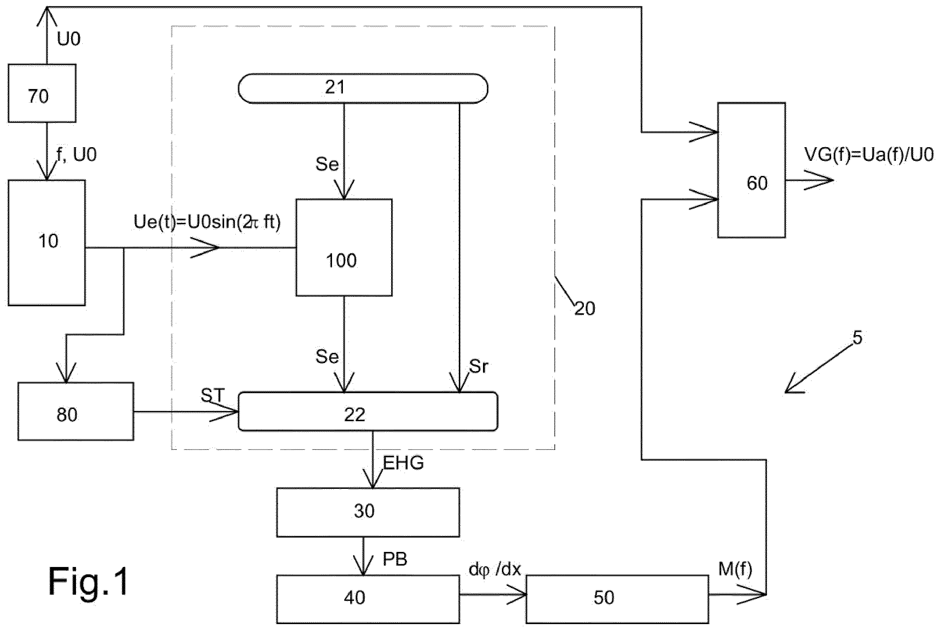

Die Figur 1 zeigt ein Ausführungsbeispiel für eine Anordnung 5 zum Erfassen eines Messwerts. Die Anordnung 5 weist einen Sinusgenerator 10 auf, der ein sinusförmiges Anregungssignal Ue erzeugt gemäß

$$Ue(t) = U0 \ \sin(2\pi \ f \ t)$$

wobei U0 die Signalamplitude des Anregungssignals, f die Anregungsfrequenz des Anregungssignals und t die Zeit bezeichnet.

Mit dem sinusförmigen Anregungssignal Ue wird ein Bauelement 100 beaufschlagt. Das Bauelement 100 befindet sich in einem Elektronenholographiemessgerät 20, das unter anderem eine Elektronenquelle 21 und eine Messeinheit 22 umfasst. Bei dem Elektronenholographiemessgerät 20 kann es sich beispielsweise um das in der Druckschrift "Gated interference for timeresolved electron holography" (T. Niermann, M. Lehmann, und T. Wagner, Ultramicroscopy 182 (2017) 54-61) beschriebene Gerät handeln.

Die Elektronenquelle 21 erzeugt einen Elektronenstrahl Se, der das Bauelement 100 durchdringt und/oder passiert und anschließend mit einem Referenzelektronenstrahl Sr überlagert wird. Die Elektronenstrahlen interferieren und bilden ein Elektronenhologramm EHG, das von der Messeinheit 22 des Elektronenholographiemessgeräts 20 gemessen und ausgangsseitig ausgegeben wird.

An die Messeinheit 22 des Elektronenholographiemessgeräts 20 ist eine Phasenbilderzeugungseinheit 30 angeschlossen, die aus dem Elektronenhologramm EHG ein Phasenbild PB rekonstruiert und ausgangsseitig an eine nachgeordnete Auswerteinheit 40 ausgibt. Die Auswerteinheit 40 kann anhand des Phasenbildes PB die Änderung der Phase φ über dem Ort x unter Bildung eines Steigungswerts dφ/dx ermitteln. Dieser Steigungswert dφ/dx kann unmittelbar als Messwert der Anordnung 5 ausgegeben werden oder stattdessen - wie beispielhaft in der Figur 1 gezeigt - in einen nachgeordneten Multiplizierer 50 eingespeist werden, der den Steigungswert dφ/dx mit einer Konstante K multipliziert und durch diese Multiplikation einen Messwert M erzeugt, der die an dem Bauelement 100 anliegende Bauelementspannung Ua angibt.

Der Messwert M bzw. die Bauelementspannung Ua, der im Allgemeinen von der Frequenz f des Anregungssignals Ue abhängig ist, gelangt zu einem nachgeordneten Quotientenbilder 60, der einen Frequenzgang VG(f) des Bauelements 100 ermitteln kann.

Die Anordnung 5 weist darüber hinaus eine Steuereinrichtung 70 auf, die den Sinusgenerator 10 ansteuert und ihm für die Durchführung eines jeden Elektronenholographiemessschritts die Signalamplitude U0 und die Anregungsfrequenz f vorgibt. Der Sinusgenerator 10 erzeugt das Anregungssignal Ue also unter Berücksichtigung der von der Steuereinrichtung 70 erhaltenen Vorgaben.

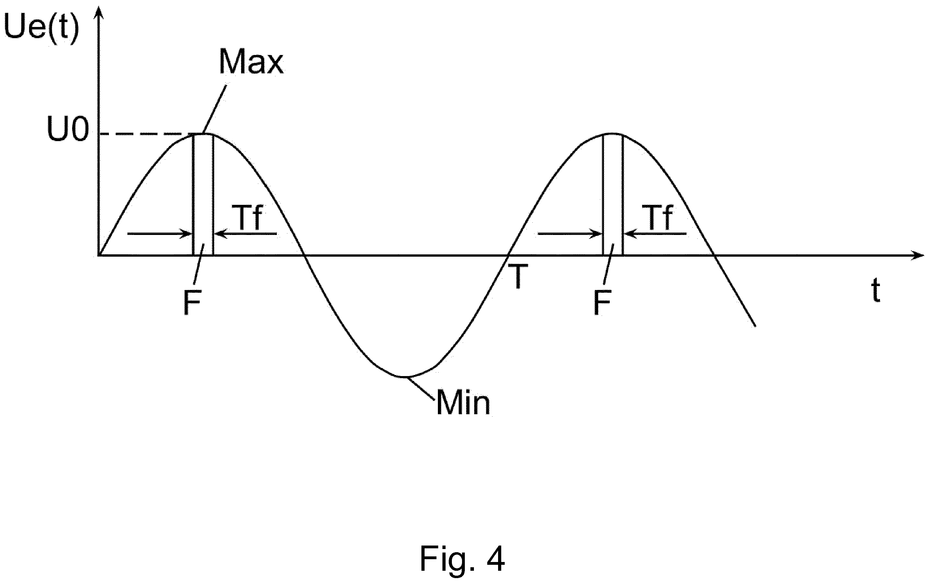

Zur Ansteuerung der Messeinheit 22 des Elektronenholographiemessgeräts 20 weist die Anordnung 5 eine Messfenstersteuereinheit 80 auf, die die zeitliche Länge Tf des Messfensters F (vgl. Figur 4) sowie die zeitliche Lage des Messfensters F relativ zum zeitlichen Verlauf des Anregungssignals Ue festlegt. Die Festlegung wird beispielhaft weiter unten im Zusammenhang mit der Figur 4 erläutert.

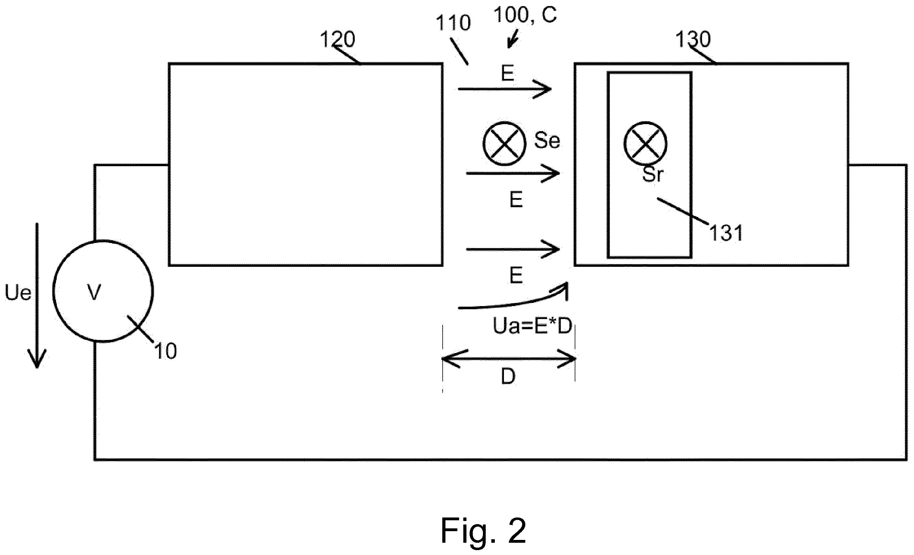

Ein Ausführungsbeispiel für das Bauelement 100 gemäß Figur 1 ist in einer schematischen Draufsicht näher in Figur 2 gezeigt. Bei dem Bauelement 100 handelt es sich um eine Kapazität C, die durch einen Spalt 110 zwischen einer in der Figur 2 linken Leiterbahn 120 und einer in der Figur 2 rechten Leiterbahn 130 gebildet ist. Der Sinusgenerator 10 gemäß Figur 1 ist an die zwei Leiterbahnen 120 und 130 angeschlossen und beaufschlagt die Reihenschaltung aus den zwei Leiterbahnen 120 und 130 und der Kapazität C mit dem Anregungssignal Ue.

Zur Messung der Spannung an der Kapazität C wird der Elektronenstrahl Se durch den Spalt 110 zwischen den zwei Leiterbahnen 120 und 130 gestrahlt, so dass dieser mit dem elektrischen Feld E bzw. dem elektrischen Potenzial zwischen den zwei Leiterbahnen 120 und 130 beaufschlagt wird. Die an dem Spalt 110 und damit an der Kapazität C abfallende Bauelementspannung ist mit dem Bezugszeichen Ua gekennzeichnet und ergibt sich wie folgt:

$$Ua = E * D$$

wobei D die Breite des Spalts 110 kennzeichnet.

Um zu gewährleisten, dass der Referenzelektronenstrahl Sr das Bauelement 100 bzw. die Kapazität C ungestört passieren kann und von dem dort anliegenden Feld E nicht beeinflusst wird, ist die in der Figur 2 rechte Leiterbahn 130 mit einer Ausnehmung 131 versehen, die ein ungestörtes Passieren des Referenzelektronenstrahls Sr ermöglicht.

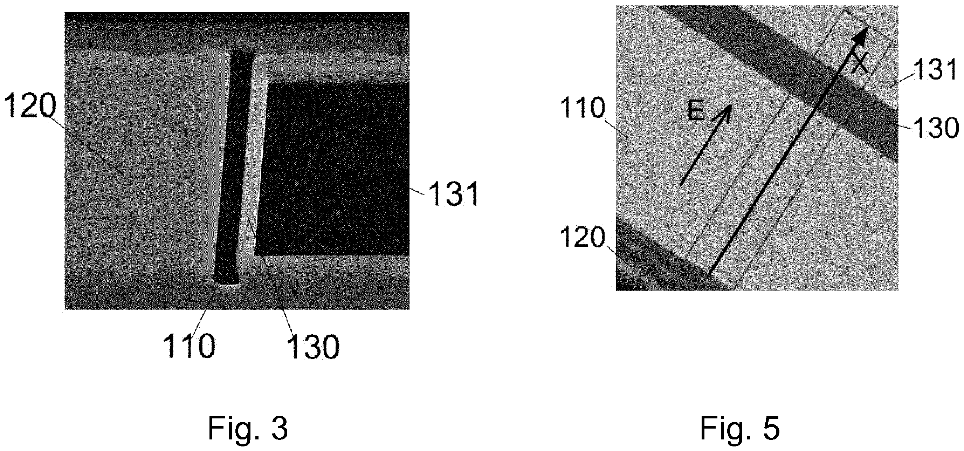

Die Figur 3 zeigt die beiden Leiterbahnen 120 und 130 sowie den dazwischen befindlichen Spalt 110 in Form einer Aufnahme, die von einem Elektronenmikroskop erzeugt worden ist. Die Spaltbreite D des Spalts 110 kann beispielsweise 3 μm betragen.

Die Anordnung 5 gemäß Figur 1 kann beispielsweise wie folgt betrieben werden:
Der Sinusgenerator 10 erzeugt ausgangsseitig das Anregungssignal Ue und speist dieses in das Bauelement 100 ein. Die Amplitude U0 und die Frequenz f des Anregungssignals Ue werden von der Steuereinrichtung 70 vorgegeben. Für jeden Elektronenholographiemessschritt kann jeweils individuell eine Frequenz f vorgegeben werden; während einer Messung mit mehreren Elektronenholographiemessschritten kann also bei jedem Schritt jeweils eine andere Anregungsfrequenz f eingestellt werden und so beispielsweise ein Frequenzgang VG(f) eines Bauelements gemessen werden.

Aufgrund des Anregungssignals Ue entsteht im Spalt 110 zwischen den Leiterbahnen 120 und 130 das elektrische Feld E, das den Elektronenstrahl Se beeinflusst; der Referenzelektronenstrahl Sr bleibt davon unbeeinflusst.

Die Messeinheit 22 des Elektronenholographiemessgerätes 20 wird von der Messfenstersteuereinheit 80 angesteuert, und zwar vorzugsweise derart, dass die Lage eines jeden Messfensters F während eines jeden Elektronenholographiemessschritts an die jeweilige Anregungsfrequenz f des Anregungssignals Ue anpasst ist. Hierzu erzeugt die Messfenstersteuereinheit 80 ausgangsseitig ein Steuersignal ST, das die zeitliche Länge Tf sowie die zeitliche Lage des Messfensters F relativ zum zeitlichen Verlauf des Anregungssignals Ue festlegt. Dies wird nachfolgend näher im Zusammenhang mit der Figur 4 erläutert. Unter dem Begriff Messfenster ist hier diejenige Zeitspanne zu verstehen, in der jeweils ein Elektronenhologramm EHG aufgenommen wird.

Die Figur 4 zeigt ein Ausführungsbeispiel für ein Anregungssignal Ue, das von dem Sinusgenerator 10 zur Ansteuerung des Bauelements 100 erzeugt werden kann. Es lässt sich erkennen, dass die Messfenstersteuereinheit 80 die zeitliche Länge Tf des Messfensters F derart klein wählt, dass diese stets kleiner ist als die Hälfte der Periodendauer T des Anregungssignals Ue. Besonders vorteilhaft ist es, wenn die Länge Tf des Messfensters F maximal 5 % der Periodendauer T des Anregungssignals Ue beträgt und bei jedem Elektronenholographiemessschritt die Lage des Messfensters - bezogen auf die gewählte Extremstelle (Maximum oder Minimum) jeweils gleich ist. Darüber hinaus sorgt die Messfenstersteuereinheit 80 dafür, dass die Lage des Messfensters F derart gewählt wird, dass das Messfenster F im Bereich einer Extremstelle des Anregungssignals Ue liegt. Bei dem Ausführungsbeispiel gemäß Figur 4 liegt das Messfenster F im Bereich eines Maximums Max des Anregungssignals Ue. Besonders vorteilhaft ist es, wenn die Fenstermitte des Fensters F mit der gewählten Extremstelle, bei dem Ausführungsbeispiel gemäß Figur 4 also dem Maximum Max, zusammenfällt.

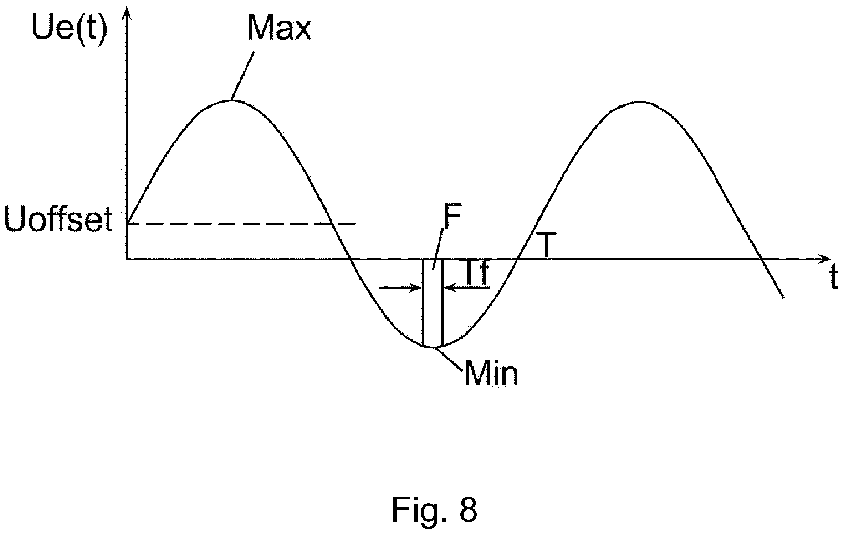

Die Auswahl des Maximums Max als Extremstelle ist bei dem Ausführungsbeispiel gemäß Figur 4 nur beispielhaft zu verstehen; statt des Maximums kann das Messfenster F auch im Bereich eines Minimums Min des Anregungssignals Ue liegen, wie weiter unten im Zusammenhang mit der Figur 8 erläutert wird. Auch muss das Anregungssignal Ue nicht zwingend allein sinusförmig sein, stattdessen kann auch ein Gleichanteil überlagert sein; auch dies wird weiter unten im Zusammenhang mit der Figur 8 erläutert.

Die Figur 5 zeigt ein Ausführungsbeispiel für ein Elektronenhologramm EHG, das von der Messeinheit 22 des Elektronenholographiemessgerätes 20 erfasst wird. Die Figur 5 zeigt in einer Draufsicht die beiden Leiterbahnen 120 und 130, den Spalt 110 zwischen den Leiterbahnen sowie darüber hinaus die Ausnehmung 131 in der Leiterbahn 130. Der in der Figur 5 die X-Koordinate angebende Pfeil erstreckt sich also von der Leiterbahn 120 durch den Spalt 110 bis in den Bereich der Ausnehmung 131 der Leiterbahn 130 hinein.

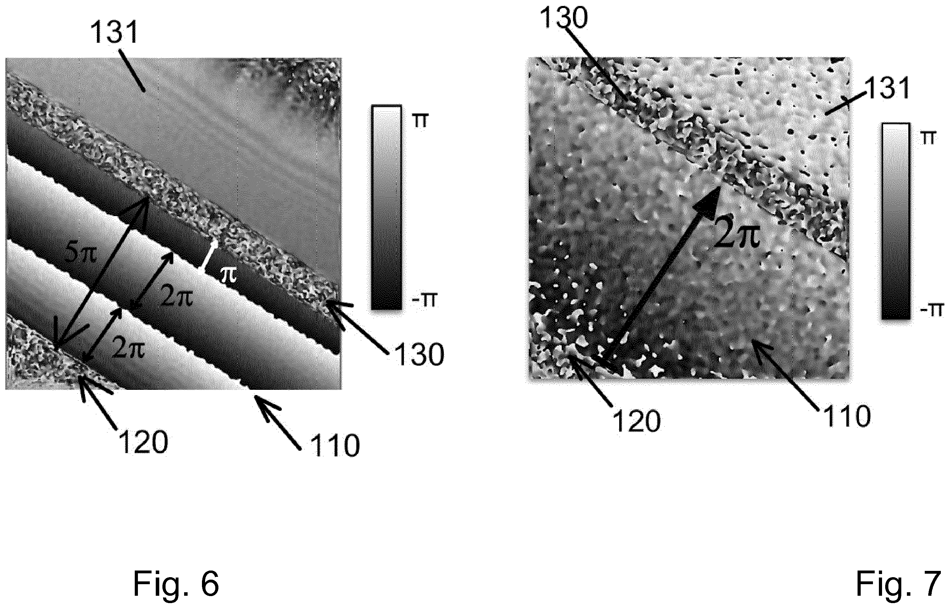

Das Elektronenhologramm EHG wird von der Phasenbilderzeugungseinheit 30 gemäß Figur 1 ausgewertet und es wird ein Phasenbild PB extrahiert, das für eine Amplitude U0 des Anregungssignals Ue von beispielsweise 0,5 V in der Figur 6 näher gezeigt ist. Es lässt sich erkennen, dass im Spalt 110 zweieinhalb Phasensprünge auftreten, also zwischen den zwei Leiterbahnen 120 und 130 ein Phasenversatz von insgesamt 5 π auftritt.

Die Auswerteinheit 40 kann unter Berücksichtigung der Spaltbreite D von 3 μm zwischen den zwei Leiterbahnen 120 und 130 nun die Änderung der Phase über dem Ort unter Bildung eines Steigungswertes dφ/dx ermitteln, und zwar gemäß:

$$d\varphi/dx = 5\pi/D = 5,2\ \text{rad}/\mu\text{m}.$$

Der Steigungswert dφ/dx kann unmittelbar als Messwert der Anordnung 5 ausgegeben werden. Alternativ oder zusätzlich kann - wie bei dem Ausführungsbeispiel gemäß Figur 1 - der Steigungswert dφ/dx an den Multiplizierer 50 weitergegeben, der den Steigungswert dφ/dx mit einer für das Elektronenholographiemessgerät 20 ermittelten Konstante K multipliziert und ausgangsseitig einen Messwert erzeugt, der die an der Kapazität C gemäß Figur 2 anliegende Bauelementspannung Ua errechnen gemäß

$$Ua = K * d\varphi/dx.$$

Die Konstante K kann beispielsweise unter Heranziehung von Referenzmessungen mit anderen Messeinrichtungen ermittelt werden. Beispielsweise kann die Spannung an der Kapazität C vorher oder nachher mit einem anderen herkömmlichen Messgerät gemessen werden und das Messergebnis kann anschließend zur Kalibrierung des Elektronenholographiemessgeräts 20 bzw. zur Bestimmung der Konstante K genutzt werden.

Für die in den Figuren 6 und 7 gezeigten Phasenbilder wurde ein Elektronenholographiemessgerät 20 verwendet, bei dem die Konstante K von 0,0962 Vpm/rad beträgt, so dass sich aus dem obigen Steigungswert dφ/dx von 5,2 rad/pm eine Bauelementspannung Ua von 0,5 V ergibt.

In der beschriebenen Weise kann eine Vielzahl an Elektronenholographiemessschritten für unterschiedliche Anregungsfrequenzen f durchgeführt werden, die von der Steuereinrichtung 70 vorgegeben werden.

Bei dem Ausführungsbeispiel gemäß den Figuren 2 und 3 bildet die Kapazität C mit den Leiterbahnen 120 und 130 einen Tiefpass, so dass die an der Kapazität C anliegende Bauelementspannung Ua frequenzabhängig ist und mit höheren Frequenzen abnimmt. Es gilt hier

$$Ua = Ue/(2\pi f\ RC)$$

wobei R den Widerstand der beiden Leiterbahnen 120 und 130 und C die Kapazität bezeichnet.

Wird also die Anregungsfrequenz f im Anregungssignal Ue erhöht, so wird die Bauelementspannung Ua an der Kapazität C abfallen. Dieser Sachverhalt ist in der Figur 7 ersichtlich, bei der das Phasenbild für eine Messung mit einer höheren Anregungsfrequenz f von 3 MHz dargestellt ist. Es lässt sich erkennen, dass die Phasendifferenz φ zwischen den Leiterbahnen 120 und 130 nur noch 2π beträgt, also die Spannung Ua an der Kapazität C um den Faktor 2,5 kleiner ist als bei der Anregungsfrequenz von 1 kHz gemäß Figur 6.

Bei der Darstellung gemäß Figur 7 ist die Darstellung des Phasenbildes PB sehr viel grobkörniger als bei der Darstellung gemäß Figur 6, was damit zusammenhängt, dass die Anregungsfrequenz f des Anregungssignals Ue beim Elektronenholographiemessschritt gemäß Figur 7 deutlich größer ist als bei dem Elektronenholographiemessschritt gemäß Figur 6 und damit die zeitliche Länge des Messfensters Tf deutlich kleiner ist als bei dem Messschritt gemäß Figur 6. Als besonders vorteilhaft wird es nämlich angesehen, wenn im Falle mehrerer Elektronenholographiemessschritte nacheinander mit unterschiedlichen Periodenlängen T des Anregungssignals Ue jeweils die zeitliche Länge Tf des Messfensters F an die jeweilige Periodenlänge T des Anregungssignals Ue angepasst wird, und zwar derart, dass das Verhältnis Tf/T zwischen der Länge Tf des Messfensters F und der jeweiligen Periodenlänge T des Anregungssignals Ue bei allen Elektronenholographiemessschritten gleich groß ist. Auch ist bei jedem Elektronenholographiemessschritt die Lage des Messfensters - bezogen auf das Maximum oder Minimum des sinusförmigen Anregungssignals - vorzugsweise jeweils gleich; besonders bevorzugt liegt die Fenstermitte eines jeden Messfensters jeweils bei allen Elektronenholographiemessschritten genau auf der ausgewählten Extremsstelle (Maximum oder Minimum) des Anregungssignals.

Durch Durchführung mehrerer Elektronenholographiemessschritte nacheinander mit unterschiedlichen Anregungsfrequenzen f lässt sich somit der Frequenzgang VG(f) für die Spannung Ua an der Kapazität C angegeben gemäß

$$V(f) = Ua(f)/U0.$$

Die Figur 8 zeigt zur weiteren Erläuterung noch ein weiteres Ausführungsbeispiel für ein Anregungssignal Ue, das zur Anregung des Bauelements 100 während der Durchführung der Messung mittels der Anordnung 5 gemäß Figur 1 erzeugt werden kann. Es lässt sich erkennen, dass das Anregungssignal sinusförmig ist, jedoch um einen Gleichanteil Uoffset versetzt ist.

Darüber hinaus zeigt die Figur 8, dass die Messfenstersteuereinheit 80 das Messfenster F nicht zwingend in den Bereich des Maximums Max legen muss, alternativ kann sie das Messfenster F beispielsweise auch in den Bereich des Minimums Min des Anregungssignals Ue legen. Auch hier ist es vorteilhaft, wenn bei allen Elektronenholographiemessschritten unabhängig von der Anregungsfrequenz die Fenstermitte genau an der Extremstelle (hier also dem Minimum) liegt.

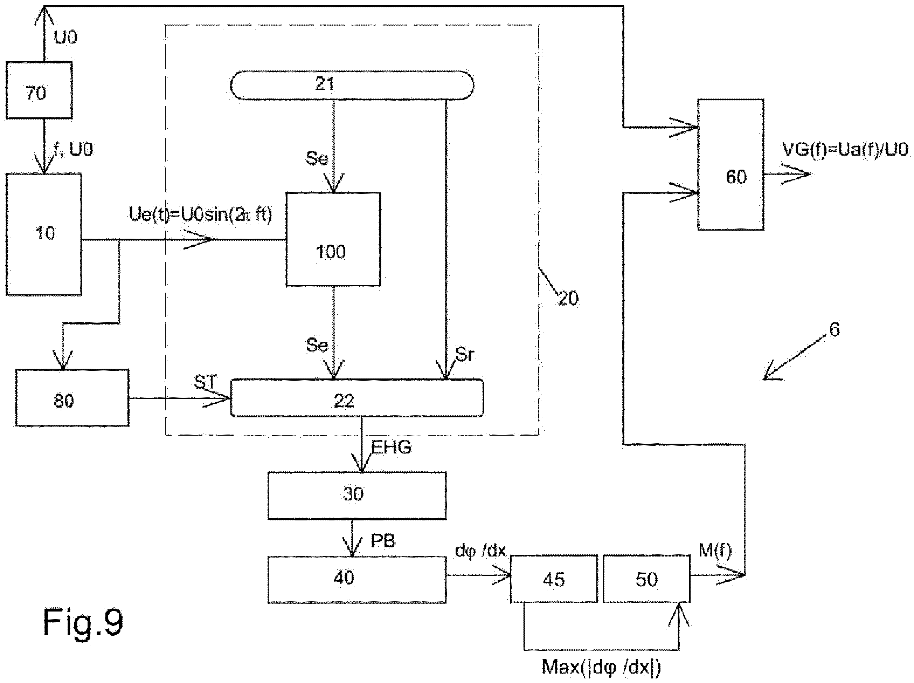

Die Figur 9 zeigt ein Ausführungsbeispiel für eine alternative Anordnung 6 zum Erfassen eines Messwerts. Die alternative Anordnung 6 stellt eine Abwandlung der Anordnung 5 gemäß Figur 1 dar, welche sich in zwei Punkten von der Anordnung 5 unterscheidet.

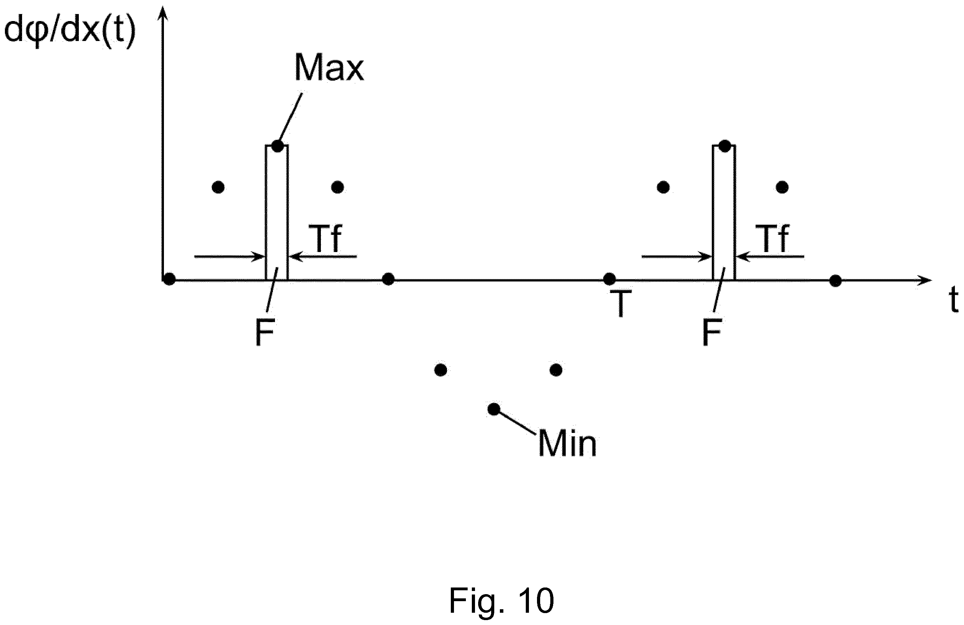

Die Messfenstersteuereinheit 80 wählt die Lage des Messfensters F derart, dass das Messfenster an mehreren äquidistanten Stellen, zumindest jedoch vier äquidistanten Stellen des Anregungssignals liegt, um mehrere, zumindest aber vier, Elektronenholographiemessschritte nacheinander bei gleichen Periodenlängen des Anregungssignals durchzuführen. Dies wird nachfolgend näher im Zusammenhang mit der Figur 10 erläutert.

Die somit generierten Elektronenhologramme EHG werden von der Phasenbildungseinheit 30 in Phasenbilder PB rekonstruiert und mit der Auswerteeinheit 40 Steigungswerte dφ/dx emittelt.

Die Figur 10 zeigt ein Ausführungsbeispiel für eine Analyse der Steigungswerte dφ/dx bei äquidistanten Messfensterpositionen zur Ermittlung des betragsmäßig höchsten Steigungswertes Max|dφ/dx| durch eine Sortiereinheit 45.

Die Sortiereinheit 45 analysiert die ermittelten Steigungswerte dφ/dx bei äquidistanten Messfensterpositionen und ermittelt den betragsmäßig höchsten Steigungswert Max|dφ/dx|.

Der betragsmäßig höchste Steigungswert Max|dφ/dx| kann unmittelbar als Messwert der Anordnung 6 ausgegeben werden. Alternativ oder zusätzlich kann - wie bei dem Ausführungsbeispiel gemäß Figur 9 - der betragsmäßig höchste Steigungswert Max|dφ/dx| an den Multiplizierer 50 weitergegeben werden.

Im Übrigen sei bezüglich der Arbeitsweise der Messfenstersteuereinheit 80 auf die obigen Erläuterungen im Zusammenhang mit den Figuren 1 bis 10 verwiesen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| 5 | Anordnung |
|---|---|
| 6 | alternative Anordnung |
| 10 | Sinusgenerator |
| 20 | Elektronenholographiemessgerät |
| 21 | Elektronenquelle |
| 22 | Messeinheit |
| 30 | Phasenbilderzeugungseinheit |
| 40 | Auswerteinheit |
| 45 | Sortiereinheit |
| 50 | Multiplizierer |
| 60 | Quotientenbilder |
| 70 | Steuereinrichtung |
| 80 | Messfenstersteuereinheit |
| 100 | Bauelement |
| 110 | Spalt |
| 120 | Leiterbahn |
| 130 | Leiterbahn |
| 131 | Ausnehmung |
| C | Kapazität |
| D | Spaltbreite |
| E | elektrisches Feld |
| EHG | Elektronenhologramm |
| f | Anregungsfrequenz |
| F | Messfenster |
| K | Konstante |
| M | Messwert |
| Max | Maximum |
| Min | Minimum |
| PB | Phasenbild |
| Se | Elektronenstrahl |
| Sr | Referenzelektronenstrahl |
| ST(f) | Steuersignal |
| T | Periodendauer |
| Tf | zeitliche Länge |
| U0 | Spannungsamplitude |
| Ua | Bauelementspannung |
| Ue | Anregungssignal |
| Uoffset | Gleichanteil |
| VG(f) | Frequenzgang |
| x | Ort |
| φ | Phase |
| dφ/dx | Steigungswert |
| Max(|dφ/dx|) | maximaler Steigungswert |

**Patentansprüche**

1. Verfahren zum Erfassen eines Messwerts (dφ/dx, M), **dadurch gekennzeichnet, dass**

- ein sinusförmiges Anregungssignal (Ue) mit einer vorgegebenen Anregungsfrequenz (f), mit oder ohne überlagerten Gleichanteil (Uoffset), an einem Eingang eines Bauelements (100, C) eingespeist wird,

- zumindest ein Elektronenholographiemessschritt durchgeführt wird, bei dem

    - auf das Bauelement (100, C) ein Elektronenstrahl (Se) gerichtet wird, der das Bauelement (100, C) durchdringt und/oder passiert und anschließend mit einem Referenzelektronenstrahl (Sr) überlagert wird, und
    - ein durch Interferenz der zwei Elektronenstrahlen (Se, Sr) während eines vorgegebenen Messfensters (F) entstehendes Elektronenhologramm (EHG) gemessen und daraus ein Phasenbild (PB) ermittelt wird, und

    - anhand des Phasenbildes (PB) der Messwert (M) gebildet wird,
    - wobei die zeitliche Länge (Tf) des Messfensters (F) des Elektronenholographiemessschritts kleiner ist als die Hälfte der Periodendauer (T) des sinusförmigen Anregungssignals (Ue).

2. Verfahren nach Anspruch 1,
   **dadurch gekennzeichnet, dass**
   die Lage des Messfensters (F) relativ zu den Stellen maximaler Steigung des Anregungssignals (Ue) derart gewählt wird, dass das Messfenster (F) zwischen diesen Stellen liegt und diese nicht einschließt.

3. Verfahren nach einem der voranstehenden Ansprüche,
   **dadurch gekennzeichnet, dass**
   die Lage des Messfensters (F) derart gewählt wird, dass es eine Extremstelle, also entweder ein Maximum (Max) oder ein Minimum (Min), des Anregungssignals (Ue) erfasst.

4. Verfahren nach einem der voranstehenden Ansprüche,
   **dadurch gekennzeichnet, dass**
   die Lage des Messfensters (F) derart gewählt wird, dass die Fenstermitte an der oder zumindest im Bereich der Extremstelle des Anregungssignals (Ue) liegt.

5. Verfahren nach einem der voranstehenden Ansprüche,
   **dadurch gekennzeichnet, dass**
   zumindest zwei Elektronenholographiemessschritte der beschriebenen Art nacheinander mit unterschiedlichen Anregungsfrequenzen (f) durchgeführt werden.

6. Verfahren nach Anspruch 5,
   **dadurch gekennzeichnet, dass**

bei jedem der Elektronenholographiemessschritte die Länge (Tf) des Messfensters (F) und die jeweilige Periodenlänge (T) des sinusförmigen Anregungssignals (Ue) aneinander angepasst werden, und zwar derart, dass das Verhältnis zwischen der Länge (Tf) des Messfensters (F) und der jeweiligen Periodenlänge (T) des Anregungssignals (Ue) bei allen Elektronenholographiemessschritten gleich groß ist.

7. Verfahren nach einem der voranstehenden Ansprüche 5 bis 6,
   **dadurch gekennzeichnet, dass**
   bei jedem der Elektronenholographiemessschritte - unabhängig von der jeweiligen Anregungsfrequenz (f) - die Lage der Messfenster (F) bezogen auf den zeitlichen Verlauf des Anregungssignals (Ue) stets gleich ist, insbesondere die Fenstermitte stets an der oder zumindest im Bereich der ausgewählten Extremstelle des Anregungssignals (Ue) liegt.

8. Verfahren nach einem der voranstehenden Ansprüche,
   **dadurch gekennzeichnet, dass**
   anhand des Phasenbildes (PB) die Änderung der Phase über dem Ort (x) unter Bildung eines Steigungswerts (dφ/dx) ermittelt wird und als der Messwert (M) der Steigungswert (dφ/dx) ausgegeben wird oder mit dem Steigungswert (dφ/dx) der Messwert (M)) gebildet wird, insbesondere durch Multiplikation mit einer Konstante (K).

9. Verfahren nach einem der voranstehenden Ansprüche,
   **dadurch gekennzeichnet, dass**
   als Messwert (M) die an dem Bauelement (100, C) anliegende elektrische Spannung ermittelt wird.

10. Verfahren nach einem der voranstehenden Ansprüche,
    **dadurch gekennzeichnet, dass**
    als Messwert (M) der durch das Bauelement (100, C) fließende Strom ermittelt wird.

11. Verfahren nach einem der voranstehenden Ansprüche,
    **dadurch gekennzeichnet, dass**
    die zeitliche Länge (Tf) des Messfensters (F) kleiner ist als ein Fünftel der Periodendauer (T) des Anregungssignals (Ue), insbesondere kleiner als ein Achtel, vorzugsweise kleiner als ein Zehntel und besonders bevorzugt kleiner als ein Zwanzigstel der Periodendauer (T) des Sinussignals.

12. Verfahren nach einem der voranstehenden Ansprüche,
    **dadurch gekennzeichnet, dass**

    - eine Vielzahl an Elektronenholographiemessschritten der beschriebenen Art nacheinander mit unterschiedlichen Anregungsfrequenzen (f) durchgeführt wird und

- in jedem Elektronenholographiemessschritt jeweils ein Verhältniswert zwischen der Amplitude (U0) des Wechselanteils des sinusförmigen Anregungssignals (Ue) und dem Messwert (M) errechnet wird und

- mit den Verhältniswerten (V) ein Frequenzgang (VG(f)) des Bauelements (100, C) ermittelt wird.

13. Anordnung zum Erfassen eines Messwerts (M), **gekennzeichnet durch**

    - einen Sinusgenerator (10), der ein sinusförmiges Anregungssignal (Ue) mit einer vorgegebenen Anregungsfrequenz (f), mit oder ohne überlagerten Gleichanteil (Uoffset), erzeugen und in ein Bauelement (100, C) einspeisen kann,
    - ein Elektronenholographiemessgerät (20) zur Durchführung eines Elektronenholographiemessschritts, bei dem

        - auf das Bauelement (100, C) ein Elektronenstrahl (Se) gerichtet wird, der das Bauelement (100, C) durchdringt und/oder passiert und anschließend mit einem Referenzelektronenstrahl (Sr) überlagert wird, und
        - ein durch Interferenz der zwei Elektronenstrahlen während eines vorgegebenen Messfensters (F) entstehendes Elektronenhologramm (EHG) gemessen und daraus ein Phasenbild (PB) ermittelt wird,

    - eine Auswerteinheit (40) zur Bildung des Messwertes anhand des Phasenbildes (PB), und
    - eine Messfenstersteuereinheit (80), die derart ausgebildet ist, dass sie die Lage und Länge (Tf) des Messfensters (F) bestimmt, und zwar derart, dass die zeitliche Länge (Tf) des Messfensters (F) des Elektronenholographiemessschritts kleiner ist als die Hälfte der Periodendauer (T) des sinusförmigen Anregungssignals (Ue).

14. Anordnung nach Anspruch 13,
**dadurch gekennzeichnet, dass**
die Messfenstersteuereinheit (80) derart ausgebildet ist, dass sie

    - die Lage des Messfensters (F) relativ zu den Stellen maximaler Steigung des Anregungssignals (Ue) derart wählt, dass das Messfenster (F) zwischen diesen Stellen liegt und diese nicht einschließt, und/oder
    - die Lage des Messfensters (F) derart wählt, dass das Messfenster (F) eine Extremstelle, also entweder ein Maximum (Max) oder ein Minimum (Min), des Anregungssignals (Ue) erfasst, und/oder
    - die Lage des Messfensters (F) derart wählt, dass die Fenstermitte an der oder zumindest im Bereich einer Extremstelle des Anregungssignals (Ue) liegt, und/oder
    - im Falle mehrerer Elektronenholographiemessschritte nacheinander mit unterschiedlichen Periodenlängen des Anregungssignals (Ue) bei jedem Elektronenholographiemessschritt jeweils die Länge (Tf) des Messfensters (F) an die jeweilige Periodenlänge (T) des Anregungssignals (Ue) anpasst, und zwar derart, dass das Verhältnis zwischen der Länge (Tf) des Messfensters (F) und der jeweiligen Periodenlänge (T) des Anregungssignals (Ue) bei allen Elektronenholographiemessschritten gleich groß ist, und/oder
    - im Falle mehrerer Elektronenholographiemessschritte nacheinander mit unterschiedlichen Periodenlängen des Anregungssignals (Ue) bei jedem Elektronenholographiemessschritt jeweils die Lage des Messfensters (F) an die jeweilige Periodenlänge (T) des Anregungssignals (Ue) anpasst, und zwar derart, dass die Lage des Messfensters (F) bezogen auf den zeitlichen Verlauf des Anregungssignals (Ue), insbesondere bezogen auf die Extremstellen des Anregungssignals (Ue), bei allen Elektronenholographiemessschritten gleich ist.

15. Anordnung nach einem der voranstehenden Ansprüche 13 bis 14,
**dadurch gekennzeichnet, dass**
die Auswerteinheit (40) derart ausgebildet ist, dass sie anhand des Phasenbildes (PB) die Änderung der Phase ($\varphi$) über dem Ort (x) unter Bildung eines Steigungswerts ($d\varphi/dx$) ermittelt und als Messwert (M) den Steigungswert ($d\varphi/dx$) ausgibt oder mit dem Steigungswert ($d\varphi/dx$) den Messwert (M) bildet, insbesondere durch Multiplikation mit einer Konstante (K).

Fig.1

Fig. 2

Fig. 3

Fig. 5

EP 3 611 574 A1

Fig. 4

EP 3 611 574 A1

Fig. 6

Fig. 7

EP 3 611 574 A1

Fig. 8

Fig.9

EP 3 611 574 A1

16

Fig. 10

EP 3 611 574 A1

Europäisches Patentamt

European Patent Office

Office européen des brevets

**EUROPÄISCHER RECHERCHENBERICHT**

Nummer der Anmeldung

EP 18 18 8717

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | NIERMANN T ET AL: "Gated interference for time-resolved electron holography", ULTRAMICROSCOPY, Bd. 182, 19. Juni 2017 (2017-06-19), Seiten 54-61, XP085204034, ISSN: 0304-3991, DOI: 10.1016/J.ULTRAMIC.2017.06.017 * das ganze Dokument * ----- | 1-15 | INV. G03H5/00 G03H1/22 |
| A | MIGUNOV VADIM ET AL: "Prospects for quantitative and time-resolved double and continuous exposure off-axis electron holography", ULTRAMICROSCOPY, Bd. 178, 18. August 2016 (2016-08-18), Seiten 48-61, XP085014639, ISSN: 0304-3991, DOI: 10.1016/J.ULTRAMIC.2016.08.010 * Abschnitte 1.-3. and 5.; Abbildungen 1-4, 9, 10 * ----- | 1-15 | |
| A | GATEL C ET AL: "Dynamical holographic Moirés in a TEM", JOURNAL OF PHYSICS D: APPLIED PHYSICS, INSTITUTE OF PHYSICS PUBLISHING LTD, GB, Bd. 49, Nr. 32, 19. Juli 2016 (2016-07-19), Seite 324001, XP020307499, ISSN: 0022-3727, DOI: 10.1088/0022-3727/49/32/324001 [gefunden am 2016-07-19] * das ganze Dokument * ----- | 1-15 | RECHERCHIERTE SACHGEBIETE (IPC)<br><br>G03H G01R G01N H01J |

Der vorliegende Recherchenbericht wurde für alle Patentansprüche erstellt

| Recherchenort | Abschlußdatum der Recherche | Prüfer |
|---|---|---|
| München | 17. Januar 2019 | Lutz, Christoph |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

• **T. NIERMANN ; M. LEHMANN ; T. WAGNER.** Gated interference for timeresolved electron holography. *Ultramicroscopy,* 2017, vol. 182, 54-61